(19) Europäisches Patentamt / European Patent Office / Office européen des brevets

(11) **EP 3 475 955 B1**

(12) **EUROPEAN PATENT SPECIFICATION**

(45) Date of publication and mention of the grant of the patent: **30.09.2026 Bulletin 2026/40**

(21) Application number: **17815594.1**

(22) Date of filing: **12.05.2017**

(51) International Patent Classification (IPC):
***H01B 1/22*** (2006.01) ***H01B 1/02*** (2006.01)
***C03C 8/02*** (2006.01) ***C03C 8/10*** (2006.01)
***C03C 8/18*** (2006.01) ***H10F 10/14*** (2025.01)
***H10F 77/20*** (2025.01)

(52) Cooperative Patent Classification (CPC):
**H10F 77/211; C03C 8/02; C03C 8/10; C03C 8/18; H01B 1/22; H10F 10/14;** Y02E 10/547

(86) International application number:
**PCT/KR2017/004961**

(87) International publication number:
**WO 2017/222181 (28.12.2017 Gazette 2017/52)**

(54) **COMPOSITION FOR P-TYPE SOLAR CELL ELECTRODE, ELECTRODE PREPARED THEREFROM AND P-TYPE SOLAR CELL PREPARED USING THE SAME**

ZUSAMMENSETZUNG FÜR P-TYP-SOLARZELLENELEKTRODE, DARAUS HERGESTELLTE ELEKTRODE UND P-TYP-SOLARZELLE DAMIT

COMPOSITION POUR ÉLECTRODE DE CELLULE SOLAIRE DE TYPE P, ÉLECTRODE PRÉPARÉE À PARTIR DE CELLE-CI ET CELLULE SOLAIRE DE TYPE P PRÉPARÉE EN L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.06.2016 KR 20160078908**

(43) Date of publication of application:
**01.05.2019 Bulletin 2019/18**

(73) Proprietor: **Changzhou Fusion New Material Co. Ltd.**
**Jiangsu Province (CN)**

(72) Inventors:
- **PARK, Sang Hee**
  **Suwon-si**
  **Gyeonggi-do 16678 (KR)**
- **KIM, Sang Jin**
  **Suwon-si**
  **Gyeonggi-do 16678 (KR)**
- **NAM, Hee In**
  **Suwon-si**
  **Gyeonggi-do 16678 (KR)**

(74) Representative: **Michalski Hüttermann & Partner mbB**
**Kaistraße 16A**
**40221 Düsseldorf (DE)**

(56) References cited:
**EP-A1- 3 032 546**
**JP-A- 2013 201 071**
**KR-A- 20120 086 213**
**KR-A- 20150 071 632**
**KR-A- 20150 146 105**
**KR-A- 20160 014 503**
**KR-A- 20160 057 583**
**US-A1- 2015 107 664**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 475 955 B1

## Description

### Technical Field

The present invention relates to a composition for p-type solar cell electrodes, an electrode fabricated using the same, and a p-type solar cell using the same. More particularly, the present invention relates to a composition for p-type solar cell electrodes which uses glass frits including a very small amount of Al, thereby improving resistance characteristics and contact efficiency between an electrode and a wafer, an electrode fabricated using the same, and a p-type solar cell fabricated using the same.

### Background Art

Solar cells generate electricity using the photovoltaic effect of a p-n junction which converts photons of sunlight into electricity. In the solar cell, front and rear electrodes are formed on upper and lower surfaces of a semiconductor wafer or substrate with the p-n junctions, respectively. Then, the photovoltaic effect at the p-n junction is induced by sunlight entering the semiconductor wafer and electrons generated by the photovoltaic effect at the p-n junction provide electric current through the electrodes. The electrodes of the solar cell are formed on the wafer by applying, patterning, and baking an electrode composition. As the composition for solar cell electrodes, a conductive paste composition including a conductive powder, glass frits, and an organic vehicle is used.

EP 3 032 546 A1 refers to a conductive paste comprising a conductive metal or a derivative thereof, and a lead-free glass frit dispersed in an organic vehicle, wherein said lead-free glass frit comprises tellurium-bismuth-lithium-oxide. The conductive paste can be used in the preparation of an electrode of a solar cell with excellent energy conversionefficiency.

US 2015/0107664 A1 discloses a composition for solar cell electrodes, an electrode fabricated using the same, and a solar cell including the electrode, the composition including a conductive powder; a glass frit; and an organic vehicle, wherein the conductive powder includes silver powder and aluminum powder, the silver powder includes silver particles having an average particle size D50 of 1.5 $\mu$m or more in an amount of 50 wt % or more, based on a total weight of the silver powder.

As a wafer or substrate for solar cells, a silicon substrate is mainly used. Solar cells using a silicon substrate may be divided into a p-type solar cell including an n-type emitter layer formed by doping a p-type silicon substrate with dopants such as phosphorus (P) and an n-type solar cell including a p-type emitter layer formed by doping an n-type silicon substrate with dopants such as boron (B). The p-type solar cell has an advantage in that phosphorus diffusion used in formation of the emitter layer can be performed at a lower temperature than boron diffusion and mobility of electrons is faster than that of holes. However, the p-type solar cell has lower efficiency than the n-type solar cell.

Recently, in order to increase solar cell efficiency, the area of a solar cell is gradually increased and the thickness of an emitter layer is continuously reduced. Sheet resistance of a wafer increases with increasing solar cell area, thereby causing increase in contact resistance of the solar cell and deterioration in solar cell efficiency. In addition, continuous reduction in emitter thickness causes frequent shunting, which can lead to deterioration in solar cell performance.

Therefore, there is a need for a composition for p-type solar cell electrodes, which can prevent damage to a p-n junction due to an emitter layer under various sheet resistances and can improve conductivity at an interface between a wafer and an electrode so as to enhance contact resistance, thereby improving solar cell efficiency.

### Disclosure of Invention

### Technical Problem

It is an aspect of the present invention to provide a composition for p-type solar cell electrodes which can improve resistance characteristics and contact efficiency between an electrode and a substrate (wafer).

It is another aspect of the present invention to provide p-type solar cell electrodes and a p-type solar cell having excellent Fill Factor and conversion efficiency.

It is a further aspect of the present invention to provide p-type solar cell electrodes and a p-type solar cell prepared by using a composition for p-type solar cell electrodes.

### Solution to Problem

In accordance with one aspect of the present invention, there is provided a composition for p-type solar cell electrodes including:

(A) 60 wt% to 95 wt% of silver powder; (B) 0.5 wt% to 20 wt% of a glass frit; and (C) 1 wt% to 30 wt% of an organic vehicle, wherein the glass frit includes 50 ppm to 10,000 ppm of aluminum (Al).

In one embodiment, the glass frit may include tellurium and lead, and a molar ratio of tellurium to lead in the glass frit may range from 1:10 to 30: 1.
In another embodiment, the glass frit may include tellurium and bismuth, and a molar ratio of tellurium to bismuth in the glass frit may range from 1:10 to 40:1.
The composition for p-type solar cell electrodes includes: 60 wt% to 95 wt% of the silver powder; 0.5 wt% to 20 wt% of the glass frit; and 1 wt% to 30 wt% of the organic vehicle.

In addition, the glass frit may include at least one of lead (Pb) and bismuth (Bi) together with tellurium (Te).
In another embodiment, the glass frit may include tellurium and bismuth, and a molar ratio of tellurium to bismuth in the glass frit may range from 1:10 to 40:1.
The composition for p-type solar cell electrodes may further include tungsten oxide particles and/or at least one additive selected from the group consisting of a dispersant, a thixotropic agent, a plasticizer, a viscosity stabilizer, an anti-foaming agents, a pigment, a UV stabilizer, an antioxidant, and a coupling agent.
In accordance with another aspect of the present invention, there is provided a p-type solar cell electrode fabricated using the composition for p-type solar cell electrodes according to the present invention.
In accordance with a further aspect of the present invention, there is provided a p-type solar cell including: a wafer comprising a p-type substrate and an n-type emitter formed on one surface of the p-type substrate; a front electrode formed on the n-type emitter; a rear electrode formed on the other surface of the p-type substrate, wherein the front electrode is formed of the composition for p-type solar cell electrodes according to the present invention.

Advantageous Effects of Invention

The present invention provide a composition for p-type solar cell electrodes, which uses glass frits including a very small amount of Al, thereby improving resistance characteristics and contact efficiency between an electrode and a substrate (wafer) without a shunting phenomenon.
The present invention provide p-type solar cell electrodes and a p-type solar cell prepared by using a composition for p-type solar cell electrodes having excellent Fill Factor and conversion efficiency due to minimized resistance.

Brief Description of Drawings

FIG. 1 is a schematic view of a solar cell according to one embodiment of the present invention.
FIG. 2 is a diagram showing a ternary eutectic point of Ag-Al-Si.

Best Mode for Carrying out the Invention

Hereinafter, embodiments of the present invention will be described in detail.

**Composition for solar cell electrodes**

A composition for solar cell electrodes according to the present invention includes: silver powder; a glass frit; and an organic vehicle, wherein the glass frit includes 50 ppm to 10,000 ppm of aluminum (Al).

**(A) Silver powder**

The composition for solar cell electrodes according to the present invention includes silver (Ag) powder as a conductive powder. The silver powder may have a nanometer or micrometer-scale particle size. For example, the silver powder may have a particle size of dozens to several hundred nanometers, or a particle diameter of several to dozens of micrometers. Alternatively, the silver powder may be a mixture of two or more types of silver powder having different particle sizes.
The silver powder may have various particle shapes such as a spherical, flake or amorphous particle shape without limitation.
Specifically, the silver powder may have an average particle diameter (D50) of 0.1 μm to 10 μm, more specifically 0.5 μm to 5 μm. Within this range of average particle diameter, it is possible to reduce contact resistance and line

resistance. The average particle diameter may be measured using, for example, a Model 1064D (CILAS Co., Ltd.) after dispersing the silver powder in isopropyl alcohol (IPA) at 25°C for 3 minutes via ultrasonication.

The silver powder is present in an amount of 60 wt% to 95 wt% based on the total weight of the composition for solar cell electrodes. Within this range, the composition can improve conversion efficiency of a solar cell and can be easily prepared in paste form. Specifically, the silver powder may be present in an amount of 70 wt% to 90 wt% based on the total weight of the composition.

**(B) Glass frit**

The glass frit serves to form silver crystal grains in an emitter region by etching an anti-reflection layer and melting the silver powder during a baking process of the composition for solar cell electrodes. Further, the glass frit improves adhesion of the silver powder to a wafer and is softened to decrease the baking temperature during the baking process.

In the present invention, the glass frit may include 50 ppm, 100 ppm, 200 ppm, 300 ppm, 400 ppm, 500 ppm, 600 ppm, 700 ppm, 800 ppm, 900 ppm, 1,000 ppm, 1,500 ppm, 2,000 ppm, 2,500 ppm, 3,000 ppm, 3,500 ppm, 4,000 ppm, 4,500 ppm, 5,000 ppm, 5,500 ppm, 6,000 ppm, 6,500 ppm, 7,000 ppm, 7,500 ppm, 8,000 ppm, 8,500 ppm, 9,000 ppm, 9,500 ppm, or 10,000 ppm of aluminum. Alternatively, aluminum may be present in an amount ranging from one of the numerical values set forth above to another numerical value set forth above. For example, the glass frit may include 50 ppm to 10,000 ppm, specifically 100 ppm to 10,000 ppm of aluminum.

As described above, a p-type solar cell has a structure in which an emitter layer may be formed by doping one surface of a p-type substrate with dopants such as phosphorous (P), and a front electrode is formed on the emitter layer. When aluminum (Al) is bonded to the n-type emitter layer, shunting can occur. Therefore, typical compositions for a front electrode of a p-type solar cell generally do not include Al.

However, in accordance with research conducted by the present inventors, it has been found that, when a very small amount of aluminum is contained in the glass frit, resistance characteristics and contact efficiency between an electrode and a substrate (wafer) can be improved without a shunting phenomenon due to reaction between aluminum (Al) and an n-type emitter layer. It is considered that improvement in contact efficiency with the substrate and resistance characteristics are caused by the fact that eutectic reaction between the aluminum contained in the glass frit, the silver powder, and silicon contained in the substrate occurs at low temperature during baking.

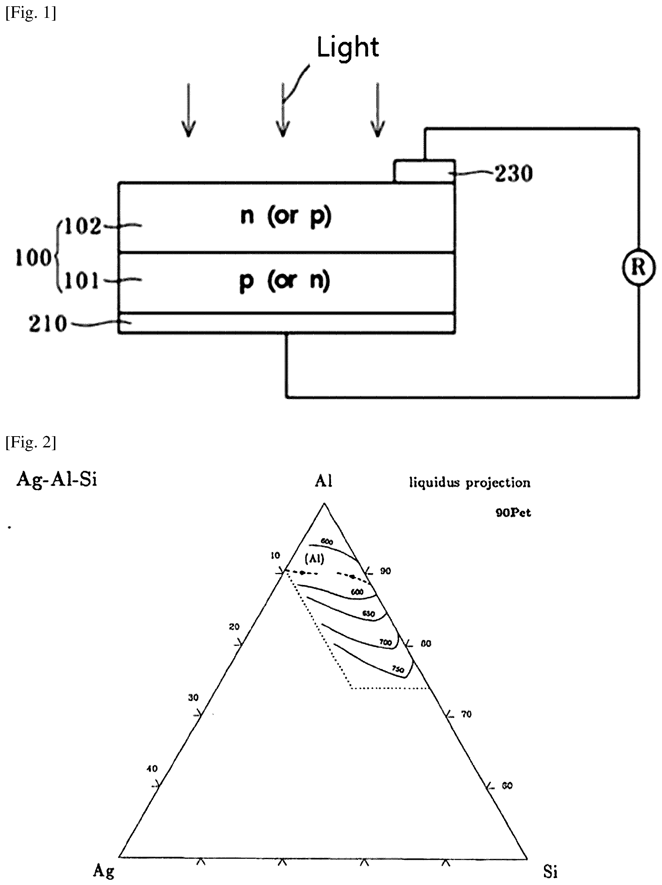

FIG. 2 is a diagram showing a ternary eutectic point of silver (Ag), aluminum (Al), and silicon (Si). Referring to FIG. 2, it can be seen that, in the ternary system of silver, aluminum, and silicon, the eutectic point decreases with decreasing content of aluminum. That is, when aluminum is present in a very small amount in the glass frit as in the present invention, eutectic reaction between aluminum in the glass frit, silver powder, and silicon in the substrate can occur at low temperature, causing increase in sintering rate, and the silver powder is melted in a liquid state at the sintering temperature of the electrode, causing liquid phase sintering, thereby reducing contact resistance with a surface of the silicon substrate (wafer). If more than 10,000 ppm of aluminum is contained in the glass frit, aluminum contained in the glass frit can react with the n-type emitter layer, thereby causing shunting. Thus, such a glass frit which comprises of aluminum (Al) of more than 10,000 ppm is not suitable for a p-type solar cell.

In addition to aluminum (Al), the glass frit may further include tellurium (Te) and may be a tellurium oxide ($TeO_2$)-based glass frit including 10 wt% to 80 wt% of tellurium oxide.

The glass frit may further include at least one of lead (Pb) and bismuth (Bi), together with aluminum (Al) and tellurium (Te).

In one embodiment, the glass frit may be a Te-Pb-O-based glass frit including tellurium and lead. Here, in the glass frit, a molar ratio of tellurium to lead may be 1:10, 1:5, 1:2, 1:1, 2:1, 5:1, 10:1, 15:1, 20:1, 25:1, or 30:1. Alternatively, the molar ratio of tellurium to lead may range from one of the numerical values set forth above to another numerical value set forth above. For example, the molar ratio of tellurium to lead may range from 1:10 to 30:1, specifically 1:5 to 20:1.

In another embodiment, the glass frit may be a Te-Bi-O-based glass frit including tellurium and bismuth. In the glass frit, a molar ratio of tellurium to bismuth may be 1:10, 1:5, 1:2, 1:1, 2:1, 5:1, 10:1, 15:1, 20:1, 25:1, 30:1, 35:1, or 40:1. Alternatively, the molar ratio of tellurium to bismuth may range from one of the numerical values set forth above to another numerical value set forth above. For example, the molar ratio of tellurium to bismuth may range from 1:10 to 40:1, specifically 1:5 to 30:1.

The glass frit may further include a metal and/or a metal oxide in addition to aluminum, tellurium, and lead and/or bismuth. For example, the glass frit may further include at least one selected from the group consisting of lithium (Li), phosphorus (P), germanium (Ge), gallium (Ga), cerium (Ce), iron (Fe), silicon (Si), zinc (Zn), tungsten (W), magnesium (Mg), cesium (Cs), strontium (Sr), molybdenum (Mo), titanium (Ti), tin (Sn), indium (In), vanadium (V), barium (Ba), nickel (Ni), copper (Cu), sodium (Na), potassium (K), arsenic (As), cobalt (Co), zirconium (Zr), manganese (Mn), and oxides thereof.

The glass frit may be prepared by any typical method known in the art. For example, the glass frit may be prepared by mixing the above-described components using a ball mill or a planetary mill, melting the mixture at 900°C to 1300°C, and

quenching the melted mixture to 25°C, followed by pulverizing the obtained product using a disk mill, a planetary mill or the like.

The glass frit may have an average particle diameter (D50) of 0.1 μm to 10 μm, without being limited thereto. In addition, the glass frit may have various shapes such as a spherical or amorphous shape without limitation.

The glass frit is present in an amount of 0.5 wt% to 20 wt%, for example, 3 wt% to 15 wt%, based on the total weight of the composition for solar cell electrodes. Within this range, the glass frit can secure stability of a p-n junction under various sheet resistances, minimize resistance, and ultimately improve solar cell efficiency.

**(C) Organic vehicle**

The organic vehicle imparts suitable viscosity and rheological characteristics for printing to the composition for solar cell electrodes through mechanical mixing with the inorganic component of the composition.

The organic vehicle may be any typical organic vehicle used in a composition for solar cell electrodes and may include a binder resin, a solvent, and the like.

The binder resin may be selected from acrylate resins or cellulose resins. Ethyl cellulose is generally used as the binder resin. In addition, the binder resin may be selected from among ethyl hydroxyethyl cellulose, nitrocellulose, blends of ethyl cellulose and phenol resins, alkyd, phenol, acrylate ester, xylene, polybutane, polyester, urea, melamine, vinyl acetate resins, wood rosin, polymethacrylates of alcohols, and the like.

The solvent may be selected from the group consisting of, for example, hexane, toluene, ethyl cellosolve, cyclohexanone, butyl cellosolve, butyl carbitol (diethylene glycol monobutyl ether), dibutyl carbitol (diethylene glycol dibutyl ether), butyl carbitol acetate (diethylene glycol monobutyl ether acetate), propylene glycol monomethyl ether, hexylene glycol, terpineol, methylethylketone, benzylalcohol, γ-butyrolactone, and ethyl lactate. These may be used alone or as a mixture thereof.

The organic vehicle is present in an amount of 1 wt% to 30 wt% based on the total weight of the composition for solar cell electrodes. Within this range, the organic vehicle can provide sufficient adhesive strength and excellent printability to the composition.

**(D) Metal oxide**

The composition for solar cell electrodes according to the present invention may further include metal oxide particles, as needed, in addition to the aforementioned components.

A solar cell may include multiple cells. Here, adjacent cells are connected to one another through a ribbon. The ribbon may be directly bonded to a busbar-type electrode. If adhesive strength of the solar cell electrode to the ribbon is not sufficiently secured, a cell can be detached or reliability of the solar cell can be deteriorated. The metal oxide particles serve to improve the adhesive strength between the electrode and the ribbon, and may be, for example, tungsten oxide ($WO_3$) particles.

Here, the tungsten oxide ($WO_3$) particles may take the form of powder or granules. The tungsten oxide ($WO_3$) particles may have an average particle size (D50) of for example, 0.1 μm to 10 μm, specifically 0.1 μm to 5 μm before sintering. Within this range, a solar cell electrode fabricated using the composition can have excellent adhesive strength and photoelectric conversion efficiency.

The tungsten oxide particles may be present in an amount of 0.1 wt% to 1.0 wt% based on the total weight of the electrode paste. Within this range, it is possible to form a precise pattern when the electrode is etched. In addition, the tungsten oxide particles can improve the open-circuit voltage of the electrode while securing excellent adhesive strength of the electrode.

**(E) Additives**

The composition for solar cell electrodes according to the present invention may further include typical additives to enhance fluidity, process properties and stability, as needed. The additives may include dispersants, thixotropic agents, plasticizers, viscosity stabilizers, anti-foaming agents, pigments, UV stabilizers, antioxidants, coupling agents, and the like. These additives may be used alone or as mixtures thereof. The additives may be present in an amount of 0.1 wt% to 5 wt% based on the total weight of the composition for solar cell electrodes, without being limited thereto.

The composition according to the present invention uses a glass frit including a very small amount of Al such that eutectic reaction between aluminum, silver powder, and silicon can occur during baking of an electrode to induce liquid phase sintering, thereby improving resistance characteristics and contact efficiency between the electrode and a wafer. In addition, the composition includes a very small amount of aluminum and thus does not cause shunting even when applied to a p-type solar cell.

**Solar cell electrode and solar cell including the same**

Other aspects of the invention relate to an electrode formed of the composition for solar cell electrodes and a solar cell including the same. FIG. 1 shows a solar cell in accordance with one embodiment of the present invention.

Referring to FIG. 1, a solar cell according to the present invention may include: a wafer 100 including a p-type substrate 101 and an n-type emitter 102 formed on one surface of the p-type substrate; a front electrode 230 formed on the n-type emitter; and a rear electrode 210 formed on the other surface of the p-type substrate 101.

Here, the n-type emitter 102 may be formed by doping one surface of the p-type substrate 101 with dopants such as antimony (Sb), arsenic (As), or phosphorus (P), which is a group V element.

The front electrode 230 may be formed of the composition for solar cell electrodes according to the present invention, and the rear electrode 210 may be formed of an aluminum paste. Specifically, the front electrode (P+ electrode) 230 may be formed by printing the composition for solar cell electrodes on a front surface of the wafer 100 including the p-type substrate 101 and the n-type emitter 102, followed by baking, and the rear electrode 210 may be formed by applying the aluminum paste to the back surface of the wafer, followed by baking. For example, a preliminary process of forming the rear electrode is performed by printing the composition on the back surface of the wafer and drying the printed composition at 200°C to 400°C for 10 to 60 seconds. Further, a preliminary process of forming the front electrode may be performed by printing the composition on the front surface of the wafer and drying the printed composition. Then, the front electrode 230 and the rear electrode 210 may be formed by baking the wafer at 400°C to 950°C, specifically at 850°C to 950°C, for 30 to 50 seconds.

Mode for the Invention

Next, the present invention will be described in more detail with reference to examples. However, it should be noted that these examples are provided for illustration only and should not be construed in any way as limiting the invention.

**Examples and Comparative Examples**

As an organic binder, 1.0 wt% of ethylcellulose (STD4, Dow Chemical Company) was sufficiently dissolved in 6.2 wt% of Texanol at 60°C, and 89.0 wt% of spherical silver powder (AG-4-8, Dowa Hightech Co., Ltd.) having an average particle diameter of 1.0 μm, 3.0 wt% of a glass frit prepared according to the composition as listed in Table 1, 0.2 wt% of a dispersant BYK102 (BYK-Chemie), 0.3 wt% of a thixotropic agent Thixatrol ST (Elementis Co., Ltd.), and 0.3 wt% of tungsten oxide particles were added to the binder solution, followed by mixing and kneading in a 3-roll kneader, thereby preparing an electrode paste.

**Table 1**

| | Glass frit | Component | Al content (wt%) | Te:Pb molar ratio | Te:Bi molar ratio |
|---|---|---|---|---|---|
| Example 1 | Glass frit #1 | Pb-Te-Na-Zn-O-based | 0.31 | 1:0.60 | - |
| Example 2 | Glass frit #2 | Pb-Bi-Te-Li-W-O-based | 0.98 | 1:0.98 | 1:0.21 |
| Example 3 | Glass frit #3 | Pb-Bi-Te-Li-Zn-O-based | 0.05 | 1:0.06 | 1:0.20 |
| Example 4 | Glass frit #4 | Bi-Te-Li-Zn-O-based | 0.48 | - | 1:0.23 |
| Example 5 | Glass frit #5 | Pb-Bi-Te-Li-Na-Mg-Al-Si-O-based | 0.27 | 1:0.49 | 1:0.06 |
| Example 6 | Glass frit #6 | Pb-Bi-Te-Li-Na-Al-O-based | 0.52 | 1:0.52 | 1:0.70 |
| Comparative Example 1 | Glass frit #7 | Pb-Bi-Te-Li-Na-Mg-Al-Si-O-based | 1.98 | 1:1.03 | 1:0.22 |
| Comparative Example 2 | Glass frit #8 | Pb-Bi-Te-Li-Na-Mg-W-Si-O-based | 0.00 | 1:0.95 | 1:0.20 |

**Measurement of content (wt%) of Al in glass frit using ICP-OES**

The composition and content of each glass frit were measured in the following manner:

**Pretreatment of samples:** 0.5 g of a glass frit sample to be analyzed was placed in a beaker and correctly weighed to within 0.0001 g. 5 ml of sulfuric acid ($H_2SO_4$) was added to the beaker, followed by heating at 220°C for 3 hours using a hot plate, thereby completely carbonizing the sample. Hydrogen peroxide ($H_2O_2$) was added to the beaker until the

beaker including the carbonized sample became transparent, thereby completing pretreatment.

**Preparation of standard solution:** A standard solution of each element to be analyzed (including Al) was prepared.

**Measurement of content of metal component:** Nitric acid ($HNO_3$) was added to the beaker including the pretreated sample, followed by heating for 5 minutes and air cooling. The prepared standard solution was introduced into an ICP-OES tester (PerkinElmer, Inc.) and a calibration curve was plotted by an external standard method, followed by measuring and converting the concentration of each element in the sample using the ICP-OES tester, thereby calculating the content of Al in the glass frit.

Amount of each element (%) = Concentration of each element (ppm) × Dilution Factor (DF)/10000

$$\text{Content of Al (wt\%)} = (\text{Amount of elemental Al/Amount of all elements}) \times 100$$

## Property evaluation

### (1) Rs (series resistance), Rsh (shunt resistance), fill factor (FF, %), and conversion efficiency (Eff., %):

Each of the pastes for solar cell electrodes prepared in Examples and Comparative Examples was deposited over a front surface of a p-type substrate doped with $POCL_3$ (c-Si p-type wafer, LIGHTWAY GREEN NEW ENERGY CO., LTD.) by screen printing in a predetermined pattern, followed by drying in an IR drying furnace. Then, an aluminum paste was printed on a back surface of the wafer and dried in the same manner. A cell formed according to this procedure was subjected to baking at a temperature of 400°C to 950°C for 30 to 180 seconds in a belt-type baking furnace, thereby fabricating a solar cell. The solar cell was evaluated as to contact resistance (Rs) (ohm), shunt resistance (Rsh) (ohm), fill factor (FF, %), and conversion efficiency (Eff., %) using a solar cell efficiency tester (CT-801, Pasan Co., Ltd.).

**Table 2**

| | Rs (ohm) | Rsh (ohm) | FF (%) | Eff. (%) |
|---|---|---|---|---|
| Example 1 | 0.004628 | 20.26 | 78.42 | 19.573 |
| Example 2 | 0.004343 | 25.88 | 78.56 | 19.538 |
| Example 3 | 0.004262 | 37.35 | 78.97 | 19.573 |
| Example 4 | 0.004343 | 25.88 | 78.56 | 19.538 |
| Example 5 | 0.004345 | 24.81 | 78.90 | 19.572 |
| Example 6 | 0.004240 | 24.21 | 78.41 | 19.519 |
| Comparative Example 1 | 0.004651 | 12.08 | 78.39 | 19.331 |
| Comparative Example 2 | 0.005172 | 24.25 | 78.08 | 19.244 |

As shown in Table 2, it can be seen that the solar cells fabricated using the electrode pastes of Examples 1 to 6, which were prepared using the glass frits including Al within the range specified in the present invention, exhibited minimized shunting, that is, high shunt resistance (Rsh), and good contact resistance (Rs), and thus exhibited excellent electrical properties (fill factor and conversion efficiency). Conversely, the solar cell fabricated using the electrode paste of Comparative Example 1, which was prepared using the glass frit including Al in an amount exceeding the range specified in the present invention, had good contact resistance but underwent shunting and exhibited relatively poor electrical properties, and the solar cell fabricated using the electrode paste of Comparative Example 2 using the glass frit not including Al exhibited high contact resistance and thus poor electrical properties.

## Claims

1. A composition for p-type solar cell electrodes, **characterized in that** the composition for p-type solar cell electrodes comprises: (A) 60 wt% to 95 wt% of silver powder; (B) 0.5 wt% to 20 wt% of a glass frit; and (C) 1 wt% to 30 wt% of an organic vehicle,

wherein the glass frit comprises 50 ppm to 10,000 ppm of aluminum (Al).

2. The composition for p-type solar cell electrodes according to claim 1, wherein the glass frit comprises tellurium (Te).

3. The composition for p-type solar cell electrodes according to claim 2, wherein the glass frit comprises at least one of lead (Pb) and bismuth (Bi).

4. The composition for p-type solar cell electrodes according to claim 1, wherein the glass frit comprises tellurium and lead, and a molar ratio of tellurium to lead in the glass frit ranges from 1:10 to 30: 1.

5. The composition for p-type solar cell electrodes according to claim 1, wherein the glass frit comprises tellurium and bismuth, and a molar ratio of tellurium to bismuth in the glass frit ranges from 1:10 to 40:1.

6. The composition for p-type solar cell electrodes according to claim 1, further comprising: tungsten oxide particles.

7. The composition for p-type solar cell electrodes according to claim 1, further comprising: at least one additive selected from the group consisting of a dispersant, a thixotropic agent, a plasticizer, a viscosity stabilizer, an anti-foaming agents, a pigment, a UV stabilizer, an antioxidant, and a coupling agent.

8. A p-type solar cell electrode fabricated using the composition for p-type solar cell electrodes according to any one of claims 1 to 7.

9. A p-type solar cell comprising:

a wafer comprising a p-type substrate and an n-type emitter formed on one surface of the p-type substrate;
a front electrode formed on the n-type emitter;
a rear electrode formed on the other surface of the p-type substrate,
wherein the front electrode is formed of the composition for p-type solar cell electrodes according to any one of claims 1 to 7.

## Patentansprüche

1. Zusammensetzung für p-Typ-Solarzellenelektroden, **dadurch gekennzeichnet, dass** die Zusammensetzung für p-Typ-Solarzellenelektroden umfasst: (A) 60 Gew.-% bis 95 Gew.-% Silberpulver; (B) 0,5 Gew.-% bis 20 Gew.-% an einer Glasfritte; und (C) 1 Gew.-% bis 30 Gew.-% an einem organischen Träger,
wobei die Glasfritte 50 ppm bis 10.000 ppm Aluminium (Al) umfasst.

2. Zusammensetzung für p-Typ-Solarzellenelektroden nach Anspruch 1, wobei die Glasfritte Tellur (Te) umfasst.

3. Zusammensetzung für p-Typ-Solarzellenelektroden nach Anspruch 2, wobei die Glasfritte wenigstens eines von Blei (Pb) und Wismut (Bi) umfasst.

4. Zusammensetzung für p-Typ-Solarzellenelektroden nach Anspruch 1, wobei die Glasfritte Tellur und Blei umfasst und ein Molverhältnis von Tellur zu Blei in der Glasfritte in dem Bereich von 1:10 bis 30:1 liegt.

5. Zusammensetzung für p-Typ-Solarzellenelektroden nach Anspruch 1, wobei die Glasfritte Tellur und Wismut umfasst und ein Molverhältnis von Tellur zu Wismut in der Glasfritte in dem Bereich von 1:10 bis 40:1 liegt.

6. Zusammensetzung für p-Typ-Solarzellenelektroden nach Anspruch 1, ferner umfassend: Wolframoxidpartikel.

7. Zusammensetzung für p-Typ-Solarzellenelektroden nach Anspruch 1, ferner umfassend: wenigstens einen Zusatzstoff ausgewählt aus der Gruppe bestehend aus einem Dispergiermittel, einem thixotropen Mittel, einem Weichmacher, einem Viskositätsstabilisator, einem Antischaummittel, ein Pigment, ein UV-Stabilisator, einem Antioxidationsmittel und einem Haftvermittler.

8. p-Typ-Solarzellenelektrode, hergestellt unter Verwendung der Zusammensetzung für p-Typ-Solarzellenelektroden nach einem der Ansprüche 1 bis 7.

9. p-Typ-Solarzelle umfassend:

einen Wafer umfassend ein p-Typ-Substrat und einen n-Typ-Emitter, der auf einer Oberfläche des p-Typ-Substrats gebildet ist;
eine vordere Elektrode, die auf dem n-Typ-Emitter gebildet ist;
eine hintere Elektrode, die auf der anderen Oberfläche des p-Typ-Substrats gebildet ist,
wobei die vordere Elektrode aus der Zusammensetzung für p-Typ-Solarzellenelektroden nach einem der Ansprüche 1 bis 7 gebildet ist.

## Revendications

1. Composition pour électrodes de cellule solaire de type p, **caractérisée en ce que** la composition pour électrodes de cellule solaire de type p comprend : (A) de 60 % en poids à 95 % en poids de poudre d'argent ; (B) de 0,5 % en poids à 20 % en poids d'une fritte de verre ; et (C) de 1 % en poids à 30 % en poids d'un véhicule organique,
la fritte de verre comprenant de 50 ppm à 10 000 ppm d'aluminium (Al).

2. Composition pour électrodes de cellule solaire de type p selon la revendication 1, dans laquelle la fritte de verre comprend du tellure (Te).

3. Composition pour électrodes de cellule solaire de type p selon la revendication 2, dans laquelle la fritte de verre comprend au moins un élément parmi le plomb (Pb) et le bismuth (Bi).

4. Composition pour électrodes de cellule solaire de type p selon la revendication 1, dans laquelle la fritte de verre comprend du tellure et du plomb, et un rapport molaire du tellure au plomb dans la fritte de verre est compris entre 1/10 et 30/1.

5. Composition pour électrodes de cellule solaire de type p selon la revendication 1, dans laquelle la fritte de verre comprend du tellure et du bismuth, et un rapport molaire du tellure au bismuth dans la fritte de verre est compris entre 1/10 et 40/1.

6. Composition pour électrodes de cellule solaire de type p selon la revendication 1, comprenant en outre : des particules d'oxyde de tungstène.

7. Composition pour électrodes de cellule solaire de type p selon la revendication 1, comprenant en outre :
au moins un additif sélectionné dans le groupe constitué d'un dispersant, un agent thixotrope, un plastifiant, un stabilisant de viscosité, un agent anti-mousse, un pigment, un stabilisant UV, un antioxydant, et un agent de couplage.

8. Électrode de cellule solaire de type p fabriquée à l'aide de la composition pour des électrodes de cellule solaire de type p selon l'une quelconque des revendications 1 à 7.

9. Cellule solaire de type p comprenant :

une plaquette comprenant un substrat de type p et un émetteur de type n formé sur une surface du substrat de type p ;
une électrode avant formée sur l'émetteur de type n ;
une électrode arrière formée sur l'autre surface du substrat de type p,
l'électrode avant étant formée de la composition pour électrodes de cellule solaire de type p selon l'une quelconque des revendications 1 à 7.

[Fig. 1]

Light
230
102
100
101
210
n (or p)
p (or n)
R

[Fig. 2]

Ag-Al-Si
Al
liquidus projection
90Pct
(Al)
600
650
700
750
10
20
30
40
90
80
70
60
Ag
Si

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3032546 A1
- US 20150107664 A1